# EUROPEAN PATENT APPLICATION

(11) **EP 2 919 383 A1**
(43) Date of publication of application: **16.09.2015**
(21) Application number: 14160039.5
(22) Date of filing: 14.03.2014
(51) Int. Cl.: H03F 1/02, H03F 3/189, H03F 3/24

(54) **A radiofrequency amplifier device and configuration device, associated amplification method and configuration method**

(71) Applicant: ALCATEL LUCENT, 92100 Boulogne-Billancourt (FR)
(72) Inventor: Wantiez, Eric, 91620 NOZAY (FR); Dartois, Luc, 91620 NOZAY (FR); Roger, Morgan, 75013 PARIS (FR)
(74) Representative: Camus, Olivier Jean-Claude

(57) **Abstract**

A method for configuring a splitting function (SPF) of an outphasing splitter (OTS) of a radiofrequency amplification device (RFA) wherein an input baseband signal (IBS) is decomposed in a first outphased signal (FOS) and a second outphased signal (SOS), said first (FOS) and second (FOS) outphased signals corresponding to the input baseband signal (IBS) in an "I/Q" diagram, said method comprising the step of:
- determining a first rule (R1) in function of at least one criteria from a list of criteria (LC) representative of the characteristics of the radiofrequency amplification device (RFA),
- configuring the splitting function (SPF) with the first rule (R1) to ensure that the difference of phase (DP) between the first outphased signal (FOS) and the second outphased signal (SOS) is less than a first threshold (TH1).

## Description

### FIELD OF THE INVENTION

The present invention relates radiofrequency amplification domain, wherein achieved amplification is constrained by linearity of the amplified signal.

### BACKGROUND OF THE INVENTION

In wireless communication networking, antennas systems are critical in various aspects of a wireless network. Their efficiencies have to increase similarly to the expansion of data demand or the green networking requirements.

A key element of an efficient antenna system is the amplification phase of an input signal. Some amplification techniques using architecture such a "Doherty" structure are based on power amplification of class A, AB or C. Main advantage of such amplification architecture is to provide linear amplification on short range of input signal but with the drawback of being less efficient for input signals not comprised in the said short range. Other well-known techniques allow increasing the range of input baseband signal. These techniques are relying on linear amplification using non linear components in which amplification architectures are using power amplification of class D, E, F or S. Other techniques combine such amplification class with multi branch amplification architecture that decomposes the input signal into intermediate signals. Higher power amplification efficiency is achievable with such techniques but in return challenges are added in the design of the overall radiofrequency amplifier. Such challenges are due to the inherent limitation of existing components of the radiofrequency amplifier. For example, higher class power amplification architecture, using two amplification branches, may have an efficiency limited due to the loss of the used coupler to combine the output of the said two branches. Other challenges also reside in the ability of such higher efficiency class to process low amplitude input signal. Such low amplitude signal are usually difficult to reconstruct because the input signal is decomposed into intermediate signals with very high difference of phase, impacting for example the efficiency of the used coupler. Some other challenges are also linked to the increase of the spectrum bandwidth of the input signal that is decomposed in intermediate signals for each branch of a multi branch amplification architecture.

Some effects of these challenges may be partially solved with input signal conditioning but at the expenses of more amplification restrictions and higher cost.

The present invention aims to address the challenges described herein above by providing a cost effective solution with methods and devices for a radiofrequency amplifier device.

### SUMMARY OF THE INVENTION

The invention aims to remedy all or some of the disadvantages of the above identified prior art. It particularly proposes to amplify an input baseband signal with a radiofrequency amplifier device, comprising a splitter configured in function of the constraints of the said radiofrequency amplifier device.

A first aspect of the invention relates then to a method for configuring a splitting function of an outphasing splitter of a radiofrequency amplification device wherein an input baseband signal is decomposed in a first outphased signal and a second outphased signal, said first and second outphased signals corresponding to the input baseband signal in an "I/Q" diagram, said method comprising the step of:
- determining a first rule in function of at least one criterion from a list of criteria representative of the characteristics of the radiofrequency amplification device,
- configuring the splitting function with the first rule to ensure that the difference of phase between the first outphased signal and the second outphased signal is less than a first threshold.

Thus, thanks to these features, the splitting function of the outphasing splitter for decomposing the input baseband signal is configured by the method and according to the characteristics of the radiofrequency amplifier device. By configuring the splitting function by taking into consideration the characteristics of the radiofrequency amplifier device, the features allows ensuring a maximum difference of phase which advantageous for the overall amplification efficiency of the radiofrequency amplifier device.

According to various embodiments, such method comprises one or more of the features below, which should be considered in any possible technical combinations.

The method for configuring a splitting function comprises a step of determining a first rule in function of at least one criterion from a list of criteria, said list of criteria comprises:
- a first criteria, function of the conditioning of the input baseband signal, such as the probability distribution function or the complementary cumulative distribution function or the sampling rate of the input baseband signal,
- a second criteria, function of a first power amplifier and a second power amplifier of the radiofrequency amplification device, comprising each at least one saturation level, said first and second power amplifiers being used for amplifying respectively a first outphased radiofrequency signal and a second outphased radiofrequency signal, said first outphased radiofrequency signal being the first outphased signal converted from baseband domain to radiofrequency domain by a first radiofrequency converter, and said second outphased radiofrequency signal being the second outphased signal converted from baseband domain to radiofrequency domain by a second radiofrequency converter,
- a third criteria, function of the isolation constraints of a combiner used for combining the amplified first outphased radiofrequency signal and the amplified second outphased radiofrequency signal into an output radiofrequency signal,
- a fourth criteria, function of the linearity constraints of the output radiofrequency signal,
- a fifth criteria, function of the maximum input spectrum bandwidths of the first radiofrequency converter and the second radiofrequency converter.

The method for configuring the splitting function comprises a step of determining the first rule, wherein said first rule comprises the choice of at least one smoothing function, said at least one smoothing function being configured by a template, for decomposing the input baseband signal into the first outphased signal and the second outphased signal.

In a second aspect, the invention deals with a configuration device of a splitting function of an outphasing splitter of a radiofrequency amplification device wherein an input baseband signal is decomposed in a first outphased signal and a second outphased signal, said first and second outphased signals corresponding to the input baseband signal in a I/Q diagram, comprising:
- means to determine a first rule in function of at least one criteria of a list of criteria representative of the characteristics of the radiofrequency amplification device,
- means to configure the splitting function with the first rule to ensure that the difference of phase between the first outphased signal and the second outphased signal is less than a first threshold,
- means to configure the list of criteria, said means being an input interface or means to evaluate the criteria from the list of criteria by interacting respectively with the outphasing splitter, a first radiofrequency converter and a second radiofrequency converter, a first power amplifier and a second power amplifier, a combiner, respectively comprised in the radiofrequency amplification device.

Thus, thanks to these features, the configuration device provide means to configure the splitting function of the outphasing splitter for decomposing the input baseband signal according to the characteristics of the radiofrequency amplifier device. The configuration device is then configuring the outphasing splitter to match the characteristics of the radiofrequency amplifier device. These features allow ensuring a maximum difference of phase which is advantageous for the overall amplification efficiency of the radiofrequency amplifier device.

In a third aspect, the invention deals with a method for amplifying linearly an input baseband signal, comprising the following steps:
- decomposing the input baseband signal in a first outphased signal and a second outphased signal corresponding to the input baseband signal in a I/Q diagram, wherein the respective amplitudes and phases of the respective first outphased signal and second outphased signal are calculated in real-time, by a splitting function configured to ensure that the difference of phase between the first outphased signal and the second outphased signal is less than a first threshold, and in function of a signal criteria representative of amplitude and phase of the input baseband signal,
- converting from baseband to radiofrequency the first outphased signal and the second outphased signal into respectively a first outphased radiofrequency signal and a second outphased radiofrequency signal,
- amplifying the first outphased radiofrequency signal and the second outphased radiofrequency signal,
- combining the said amplified first outphased radiofrequency signal and second outphased radiofrequency signal, into an output radiofrequency signal.

Thus, thanks to these features, the method for amplifying linearly an input baseband signal allows to amplify the said input baseband signal according to the characteristics of said signal and to the characteristics of the radiofrequency amplifier device. These features allow ensuring an advantageous overall amplification efficiency of the radiofrequency amplifier device.

According to an embodiment, such method for amplifying linearly an input baseband signal comprises the step of decomposing the input baseband signal in the first outphased signal and the second outphased signal, and wherein the splitting function is configured according to the method for configuring the splitting function of the outphasing splitter of a radiofrequency amplification device.

In a fourth aspect, the invention relates to a radiofrequency amplification device for amplifying an input baseband signal and comprising:
- an outphasing splitter comprising a splitting function, for decomposing the input baseband signal respectively into a first outphased signal and a second outphased signal, wherein the said first and second outphased signals corresponding to the input baseband signal in a I/Q diagram, and the respective amplitudes and phases of the respective first outphased signal and second outphased signal are calculated in real-time, by said splitting function being configured to ensure that the difference of phase between the first outphased signal and the second outphased signal is less than a first threshold, and in function of a signal criteria representative of amplitude and phase of the input baseband signal,
- a first radiofrequency converter and a second radiofrequency converter to convert from baseband to radiofrequency the first outphased signal and the second outphased signal respectively into a first outphased radiofrequency signal and a second outphased radio frequency signal,
- a first power amplifier and a second power amplifier for amplifying respectively the first outphased radiofrequency signal and the second outphased radiofrequency signal,
- a combiner to combine the amplified first outphased radiofrequency signal and second outphased radiofrequency signal, into an output radiofrequency signal.

Thus, thanks to these features, the radiofrequency amplifier device is adapted to amplify an input baseband signal according to the characteristics of said signal and to the characteristics of the radiofrequency amplifier device. These features allow the radiofrequency amplifier device to operate with an advantageous overall amplification efficiency.

According to an embodiment, such radiofrequency amplifier device comprises the splitting function configured by the configuration device.

### BRIEF DESCRIPTION OF THE FIGURES

Some embodiments of the present invention are now described, by way of example only, and with reference to the accompanying drawings, in which:
- FIG. 1a is a schematic block diagram of a radiofrequency amplifier device according to the invention,
- FIG. 1b is a schematic block diagram of a radiofrequency converter,
- FIG. 1c is a schematic block diagram of another radiofrequency converter,
- FIG. 1d is a schematic block diagram of an outphasing splitter according to the invention,
- FIG. 1e is a schematic block diagram of a first rule for signal decomposition according to the invention,
- FIG. 1f is a schematic representation in a "I/Q" diagram of the decomposition of an input baseband signal according to the invention,
- FIG. 2 is a flowchart showing steps of a method to perform configuration of a splitting function according to the invention,
- FIG. 3a is a schematic representation in a "I/Q" diagram of coordinates for configuring the decomposition of an input baseband signal according to the invention,
- FIG. 3b is another schematic representation in a "I/Q" diagram of coordinates for configuring the decomposition of an input baseband signal according to the invention,
- FIG. 3c is another schematic representation in a "I/Q" diagram of coordinates for configuring the decomposition of an input baseband signal according to the invention,
- FIG. 3d is another schematic representation in a "I/Q" diagram of coordinates for configuring the decomposition of an input baseband signal according to the invention,
- FIG. 4 is a schematic block of radiofrequency amplifier device comprising a configuration device of a splitting function according to the invention.
- FIG. 5 is a flowchart showing steps of a method to perform amplification of an input signal.

The same reference number represents the same element to the same type of element on all drawings, unless stated otherwise.

### DESCRIPTION OF EMBODIMENTS

The figures and the following description illustrate specific exemplary embodiments of the invention. It will thus be appreciated that those skilled in the art will be able to devise various arrangements that, although not explicitly described or shown herein, embody the principles of the invention and are included within the scope of the invention. Furthermore, any examples described herein are intended to aid in understanding the principles of the invention, and are to be construed as being without limitation to such specifically recited examples and conditions. As a result, the invention is not limited to the specific embodiments or examples described below, but by the claims and their equivalents.

In the following description, well-known functions or constructions by the man skilled in the art are not described in detail since they would obscure the invention in unnecessary detail.

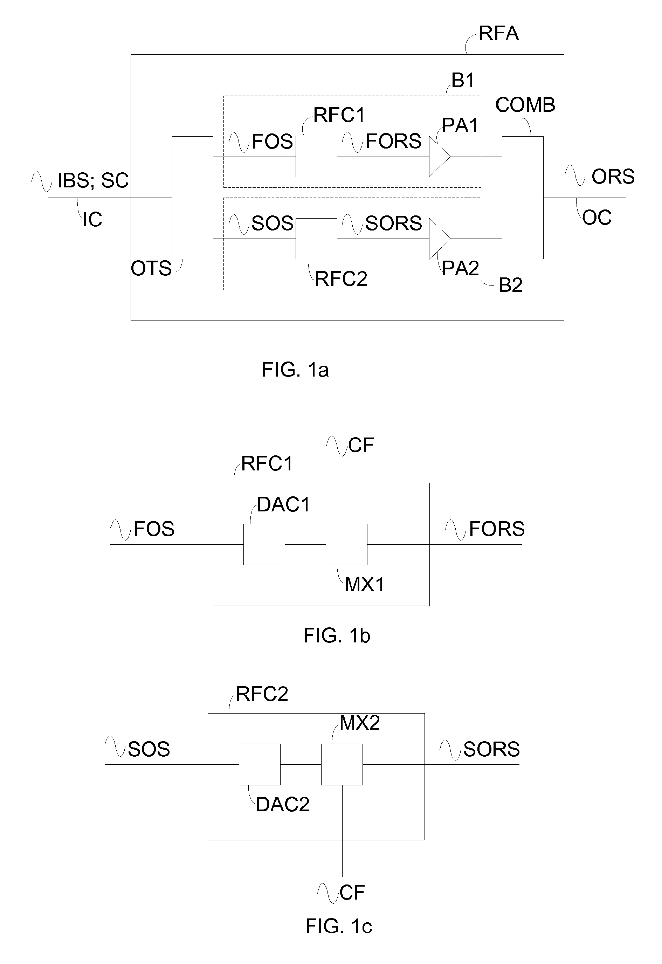

Referring to FIG. 1a, a schematic block diagram of a radiofrequency amplifier device RFA, illustrative of an embodiment of the invention, is depicted. The purpose of the radiofrequency amplifier device RFA is to amplify an input baseband signal IBS.

The radiofrequency amplifier device RFA comprises:
- an input connection IC, as an entry point for the input baseband signal IBS,
- an output connection OC, as an exit point for an output radiofrequency signal ORS,
- an outphasing splitter OTS with the input baseband signal IBS as an input, and a first outphased signal FOS and a second outphased signal SOS as outputs,
- a first radiofrequency converter RFC1 with the first outphased signal FOS as an input, and a first outphased radiofrequency signal FORS as an output,
- a second radiofrequency converter RFC2 with the second outphased signal SOS as an input, and a second outphased radiofrequency signal SORS as an output,
- a first power amplifier PA1 and a second power amplifier PA2 that amplify respectively the first outphased radiofrequency signal FORS and the second outphased radiofrequency signal SORS,
- a combiner COMB that combines the respectively amplified first outphased radiofrequency signal FORS and the second outphased radiofrequency signal SORS, into the output radiofrequency signal ORS,
- a first branch B1 that comprises:
   o the first radiofrequency converter RFC1,
   o the first power amplifier A1,
- a second branch B2 that comprises:
   o the second radiofrequency converter RFC2,
   o the second power amplifier A2

In non limiting examples, the radiofrequency amplifier device RFA is integrated in an antenna system from a base station of a cellular network. The radiofrequency amplifier device RFA may be designed to process digital baseband signals from Third Generation Partner Ship Project (3GPP) standards such as Wideband Code Division Multiple Access (W-CDMA) or Long Term Evolution (LTE) air interfaces. In other non limiting examples, the radiofrequency amplifier is able to amplify baseband signals from Wi-Fi protocols or TErrestrial Trunked Radio (TETRA). In all these non limiting examples, the digital input baseband signal IBS presents characteristics specific to the wireless standards and/or protocol, such as:
- spectrum bandwidth of the baseband signal: 5MHz for W-CDMA, up to 20MHz for LTE for examples,
- sampling rate of the baseband signal,
- Peak-to-Average Power Ratio (PAPR): for examples 10.6dB for WCDMA, or 12dB for LTE,
- Probability Distribution Function (PDF).

The said characteristics of the input baseband signal IBS define a first criteria C1 related to its conditioning, that is to be used to determine how the radio amplifier device RFA should process the said input baseband signal IBS.

In other non limiting examples, the first power amplifier PA1 and the second amplifier PA2 are power amplifiers for radiofrequencies. In traditional amplification architecture, power amplifiers are based on a "Doherty" structure and associated efficiency is categorized in class A or class AB, providing linear amplification but with limited effective dynamic range. In other amplification architectures, non linear power amplifiers in class D, E, F or S are used, providing a greater dynamic range compared to "Doherty" based amplifier but at the expense of additional constraints in the design of the radiofrequency amplifier device RFA. Such constraints are in non limiting examples:
- the conditioning of the input baseband signal needs to be adapted to the non-linear power amplifier,
- the said adaptation of the conditioning requires that the first branch B1 and the second branch B2 are properly paired. By pairing it is meant that the characteristics of each branch B1 or B2 are balanced equally. In a non limiting example, identical power amplifiers and identical radiofrequency converters on each branch are contributing to the balance or the pairing of each branch.

Such non linear power amplifiers with greater dynamic range have usually different intervals of amplification that are defined by supplying them with different voltage or power supply. These non linear power amplifiers are also usually rendering their optimal efficiency while being solicited at their saturation levels, meaning that the output amplified signals are close to the voltage or power supply. For example, amplification intervals for the first power amplifier PA1 and the second power amplifier PA2, each being able to function with 3 different voltage or power supply, respectively first saturation level SL1, second saturation level SL2, third saturation level SL3, may be [0; SL1], [SL1; SL2] and [SL2; SL3]. The first PA1 and second PA2 power amplifiers are the most efficient for amplification close but inferior to a saturation level, so advantageously the first outphased radiofrequency signal FORS and the second outphased radiofrequency signal SORS should be conditioned to be close to one of the saturation levels SL1;SL2;SL3.

In a non limiting example, the power amplifiers of the radiofrequency amplifier device RFA are multi level drain voltage amplifiers. In another non limiting example, the power amplifiers are pulse width modulated "PWM" amplifiers. In yet another non limiting example, the power amplifiers are switch modes power amplifiers "SMPA".

The constraints relative to the first (PA1) and second (PA2) power amplifiers, such as the saturation levels SL1;SL2;SL3 or the conditioning of the input signal or the pairing between the first branch B1 and second branch B2 are gathered into a second criteria C2. Similarly to first criteria C1, second criteria C2 is to be used to determine how the radio amplifier device RFA should process the said input baseband signal IBS.

In other non limiting examples, the combiner COMB is a component that outputs the desired output radiofrequency signal ORS by combining the amplified first outphased radiofrequency signal FORS and the second outphased radiofrequency signal SORS. Such combiner may be an isolated coupler operating on the said signals, or it may be a Chireix power combiner. The use of an isolated coupler adds a constraint on the maximum phase difference of the signals carried respectively by the first branch B1 and the second branch B2, otherwise the overall efficiency of the amplification of the radiofrequency amplifier RFA may be degraded. The higher the maximum of phase difference, the lower is the overall efficiency. A Chireix power combiner is less prone to dependency between maximum phase difference and overall efficiency of amplification, however the use of a Chireix power combiner adds a constraint on the load modulation generated by branch B2 and experienced on branch B1, and reversely the load modulation generated by branch B1 and experienced on branch B2. Load modulation decreases the overall efficiency of the radiofrequency amplifier RFA.

The constraints derived from the kind of combiner COMB, for example an isolated coupler or a Chireix power combiner, define a third criteria C3. Similarly to first C1 and second C2 criteria, third criteria C3 is to be used to determine how the radio amplifier device RFA should process the said input baseband signal IBS.

It has to be noted that the third criteria C3 is closely related to the maximum difference of phase between the first outphased signal FOS and the second outphased signal SOS that guarantees a given rate of efficiency of the overall radiofrequency amplifier device RFA. For example an isolated coupler is less efficient for difference of phase higher than 20°, constraint that is transposed into the third criteria C3. In another example of radiofrequency amplifier RFA, a Chireix power combiner is less efficient for difference of phase higher than 60°, constraint that is transposed into the third criteria C3.

In other non limiting examples, the linearity of the output radiofrequency signal ORS is characterizing the radiofrequency amplifier device RFA. By linearity it is meant the quality of the restitution of the characteristics of the input baseband signal IBS in terms integrity of the spectrum bandwidth of the informative part of said input baseband signal IBS, that can be endangered by of added distortion, or added clipping on the output radiofrequency signal ORS. These linearity constraints define a fourth criteria C4 to be used to determine how the radio amplifier device RFA should process the said input baseband signal IBS.

Referring to figures FIG. 1b and FIG. 1c, in yet another embodiment, a schematic block diagram of a radiofrequency converter (the first RFC1) and a schematic block diagram of another radiofrequency converter (the second RFC2) are depicted. The first radiofrequency converter RFC1 comprises:
- a first digital to analog converter DAC1 with the first outphased signal FOS as an input, and an analog first outphased signal as an output,
- a first radiofrequency mixer MX1 with the analog first outphased signal and a carrier frequency CF as inputs, and the first outphased radiofrequency signal FORS as output.

Similarly, the second radiofrequency converter RFC2 comprises:
- a second digital to analog converter DAC2 with the second outphased signal FOS as an input, and an analog second outphased signal as an output,
- a second radiofrequency mixer MX2 with the analog first outphased signal and a carrier frequency CF as inputs, and the second outphased radiofrequency signal SORS as output.

In other non limiting examples, the first (DAC1) and second (DAC2) digital to analog converters are devices to convert digital baseband signals into analog baseband signals. The processing spectrum bandwidth of the said converters is adapted to the requirements of the radiofrequency amplifier RFA, and more particularly to the spectrum bandwidth of the signals to be amplified, such as the input baseband signal IBS, and the respective first outphased signal FOS and the second outphased signal SOS. It has to be noted that the spectrum bandwidth of the first outphased signal FOS and the second outphased signal SOS may be greater than the spectrum bandwidth of the input baseband signal IBS. In particular, the greater the difference of phase between the first outphased signal FOS and the second outphased signal SOS, the greater their spectrum bandwidth can be compared to the spectrum bandwidth of the input baseband signal IBS. For technical and cost reasons on the digital to analog converters, the increase of spectrum bandwidth of the first FOS and second SOS outphased signals is to be controlled by controlling the difference of phase between the said signals. This constraint defines a fifth criteria C5 to be used to determine how the radio amplifier device RFA should process the said input baseband signal IBS.

In other non limiting examples, the first mixer MX1 and the second mixer MX2 are radiofrequency mixers to transpose an analog baseband signal into a radiofrequency signal centered on the carrier frequency CF. In wireless networks using 3GPP protocols such as LTE Frequency Division Duplex, the carrier frequency may be for example defined by the E-UTRA bands, such as band 1 [2110 MHz - 2170 MHz] or band 13 [746 MHz - 756 MHz] for the downlink transmit operating bands. For the uplink transmit operating bands in LTE FDD specifications, the carrier frequency may be for example defined by the E-UTRA band 1 [1920 MHz - 1980 MHz] or E-UTRA band 13 [777 MHz - 787 MHz].

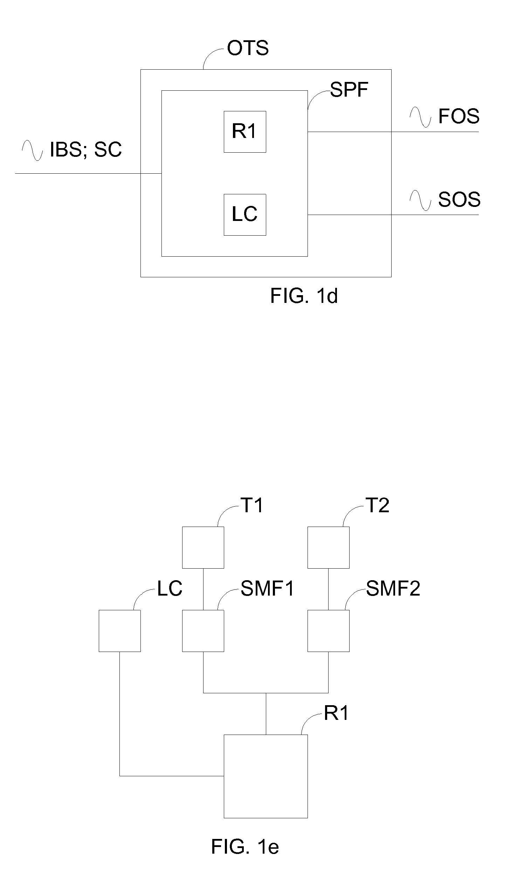

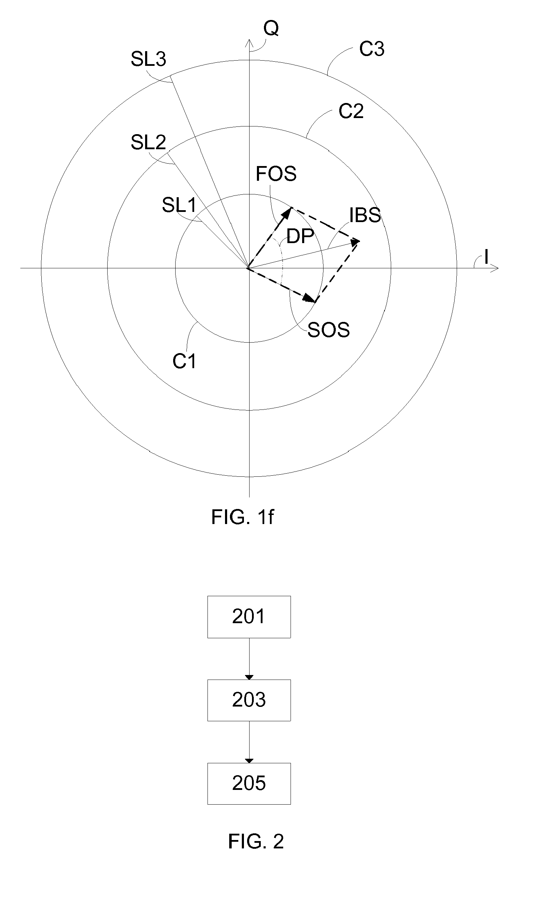

According to the elements depicted from the figures FIG. 1a, FIG. 1 band FIG. 1c, the radiofrequency amplification device RFA operation could be then described as follows:
- An input baseband signal IBS is processed by the outphasing splitter OTS that outputs the first outphased signal FOS on the first branch B1, and the second outphased signal SOS on the second branch B2. In an embodiment the first FOS and second SOS outphased signals are in baseband domain.
- On the first branch B1, the first outphased signal FOS is then processed by the first radiofrequency converter RFC1 that outputs the first outphased radiofrequency signal FORS, which is an analog signal in the radiofrequency domain. The first outphased radiofrequency signal FORS is then amplified by the first power amplifier PA1.
- Similarly on the second branch B2, the second outphased signal SOS is processed by the second radiofrequency converter RFC2 that outputs the second outphased radiofrequency signal SORS, which is an analog signal in the radiofrequency domain. The second outphased radiofrequency signal SORS is then amplified by the second power amplifier PA2.
- The first branch B1 and second branch B2 are connected to the combiner COMB that combines the first outphased radiofrequency signal FORS and the second outphased radiofrequency signal SORS and outputs the output radiofrequency signal ORS.

The output radiofrequency signal ORS is then an amplified reproduction in radiofrequency domain of the input baseband signal IBS.

Referring to figure FIG. 1d, in an embodiment, a schematic block diagram of an outphasing splitter OTS according to the invention is depicted. The outphasing splitter OTS further comprises:
- means for determining a first rule R1 in function of at least one criteria from a list of criteria LC. The said list LC comprises:
   o the first criteria C1,
   o the second criteria C2,
   o the third criteria C3,
   o the fourth criteria C4,
   o the fifth criteria C5
- a splitting function SPF, configured with the first rule R1, and with the input baseband signal IBS as input, and the first outphased signal FOS and the second outphased signal SOS as outputs,

The function of the outphasing splitter OTS is to process the input baseband signal IBS to produce the two signals, respectively the first outphased signal FOS and the second outphased signals SOS. The splitting of the input baseband signal is performed according to the first rule R1. The said first rule R1 determines the characteristics of the first outphased signal FOS and the second outphased signal SOS, such as their respective amplitudes and phases. The combination of the first outphased signal FOS and the second outphased signal SOS results in the input baseband signal IBS. In a well-known representation of signals such as an "I/Q" diagram, also known as quadrature representation with the x-axis representing real part of a signal and y-axis representing imaginary part of the same signal, said signal being complex or purely real, the sum of the first outphased signal FOS and the second outphased signal SOS results in the input baseband signal IBS, said signals are considered as vectors at a specific instant.

Referring to figure FIG. 1e, in an embodiment, a schematic block diagram of a first rule for signal decomposition according to the invention is schematized. The first rule R1 comprises the choice of a smoothing function SMF. For the illustration of the invention two smoothing functions, a first one SMF1 and second one SMF2, can be chosen, but others smoothing functions could be used and their number is not limited to 2. The first SMF1 and second SMF2 smoothing functions are respectively configured by a first template T1 and a second template T2.

The said templates T1 and T2 comprises coordinates of points in an "I/Q" diagram. These coordinates are discrete values that were pre-calculated and are stored as lookup tables, a first and second lookup table, or are calculated dynamically with polynomial functions, a first and second polynomial functions. The first template T1 or the second template T2 may comprises combination of different lookup tables or polynomial functions. For example an arrangement of the first template T1 may be combination of the first lookup table, with the second polynomial function.

In an embodiment the first T1 and second T2 templates are respectively arranged to comprises at least a set of coordinates in the "I/Q" diagram for each interval of amplification of the respective first PA1 and second PA2 power amplifiers and their associated saturation levels SL1, SL2 and SL3.

Referring to figure FIG. 1f, a schematic representation in an "I/Q" diagram of the decomposition of an input baseband signal IBS according to the invention is depicted. The said decomposition of the input baseband signal IBS, into respectively the first outphased signal FOS and the second outphased signal SOS is performed by the outphasing splitter OTS, which is configured accordingly to the list of criteria LC.

In the "I/Q" diagram, the input baseband signal IBS is represented with a vector at a given time. The said vector is the sum of two others vectors, respectively representation of the first outphased signal FOS and the second outphased signal SOS. The said outphased signal are terminating on a circle C1 defined by the first saturation level SL1. The circle C2 and circle C3 are defined respectively by the second saturation level SL2 and the third saturation level SL3.

It has to be noted that the decomposition of the input baseband signal IBS may be achieved with different combination of vectors for the first FOS and second SOS outphased signals, each decomposition being characterized by a difference of phase DP.

Referring to figure FIG. 2, a flowchart showing steps of a method to perform configuration of a splitting function SPF according to the invention is depicted. The purpose of the method to configure the splitting function is to determine the decomposition of the input baseband signal IBS.

**Step 201:** in this first step, the first rule R1 is determined in function of at least one criterion from the list LC that comprises the first C1, second C2, third C3, fourth C4, fifth C5 criteria.

In this step 201, the first rule R1 takes into account the characteristics of the radiofrequency amplifier device RFA, such as the characteristics of the input signal that has to be amplified, the constraints of the elements constituting the amplifier device, or the constraints of the amplified output signal. All the characteristics and the constraints of the radiofrequency amplifier device RFA are distributed amongst the five criteria C1, C2, C3, C4, C5 and gathered into the list LC.

**Step 203:** in this step, the splitting function SPF is configured with the first rule R1. The said configuration with this first rule R1 ensures that the decomposition of the input baseband signal IBS respectively into the first outphased signal FOS and the second outphased signal SOS is constrained by the difference of phase DP between the two produced signals. This constraint on the difference of phase DP is in a preferred embodiment to be less than a first threshold TH1.

In a non limiting example, the first threshold TH1 is dependent of the combiner COMB of the radiofrequency amplifier device, which renders the said first threshold TH1 and the third criteria C3 dependents. In order to adjust efficiency of the overall amplification of the radiofrequency amplifier device RFA, the first threshold TH1 may be chosen to ensure a smaller difference of phase DP than the one derived from the third criteria C3. In another non limiting example, the first threshold TH1 may be chosen to allow a greater difference of phase DP than the one derived from the third criteria C3, considering efficiency and tolerance margins of each element comprised in the radiofrequency amplifier device RFA. In another non limiting example, the first threshold TH1 may be updated dynamically to adapt the radiofrequency amplifier device RFA to a busy hour in terms of radio resources usage or to a low resources usage.

In another non limiting example, the method to perform configuration of a splitting function SPF is executed at the initialization of the radiofrequency amplifier device RFA. In yet another non limiting example, the method is performed again dynamically when one of the characteristics of the radiofrequency amplifier device RFA is modified.

**Step 205:** in an embodiment, the method to configure the splitting function SPF further comprises the step 205. The determination of the first rule R1 further comprises the choice of at least one smoothing function SMFi. In the exposed embodiment, two smoothing functions (a first smoothing function SMF1 and a second smoothing function SMF2) are considered but more can be defined to be chosen for the first rule R1. Indeed the more the smoothing functions are available, the more accurate the decomposition of the input baseband signal can be, in terms of consideration of the constraints of the list LC.

The first SMF1 and second SMF2 smoothing functions are functions to be applied on the input baseband signal IBS, to determine respectively the first outphased signal FOS and the second outphased signal SOS, the said smoothing functions being configured respectively by a first template T1 and a second template T2. The choice of the smoothing functions is performed accordingly to the list LC of criteria.

In a non limiting example, the first smoothing function SMF1 is adapted to the all the respective criteria C1, C2, C3, C4, C5 whereas the second smoothing function SMF2 does not match one of the criteria. In another non limiting example, the selected smoothing function is the one matching at least one of the criteria of the list LC, said criteria being identified as essential in the considered radiofrequency amplifier device. In another non limiting example, each of the first smoothing function SMF1 or second smoothing function SMF2 are adapted according to the list LC of criteria.

In a preferred embodiment, the first T1 and second T2 templates for configuring respectively the first smoothing function SMF1 and the second smoothing function SMF2 comprise coordinates in the "I/Q" diagram. For a sample of the input baseband signal IBS corresponds coordinates respectively for the first outphased signal FOS and the second outphased signal, from either the first template T1 or the second template T2. Each template (first T1 or second T2) defines profiles of coordinates for respective first FOS and second SOS outphased signals.

In this preferred embodiment, the coordinates in the "I/Q" diagram of the first T1 and second T2 templates are approximated by the first lookup table and second lookup table respectively, or are calculated by the first polynomial function and the second polynomial function respectively. It has to be noted that only two lookup tables are described in the exposed embodiment but it is apparent that more than two lookup tables may be used for the purpose of the invention. Similarly, only two polynomial functions are listed as examples, but more than two may be used for the invention.

In a non limiting example, the coordinates stored in the respective first lookup table and second lookup table are pre-calculated in function of at least one of the criteria of the list LC.

In another non limiting example, the coordinates are calculated dynamically by the first polynomial function and the second polynomial function. The said polynomial functions are tuned accordingly to the criteria of the list LC.

In yet another non limiting example, the first template T1 and the second template T2 comprises coordinates that are combination of one of the lookup tables and one of the polynomial functions.

In the step 205, describe herein above, the determination of the first rule R1 comprises then the choice of the best smoothing function for which the associated template matches optimally the list LC of criteria. It is meant by optimally, either a total match with the list of criteria, or a partial match, taking into account the maximum number of respected criteria, or a selected match, taking into account that some of the criteria may be more important than others.

In other embodiments, the first template T1 comprises a plurality of set of coordinates COi in the "I/Q" diagram. In these embodiments, one or more set of coordinates COi are associated with an amplification interval defined by the saturation levels SL1, SL2 and SL3 of the first power amplifier PA1 and the second power amplifier PA2, respectively [0; SL1], [SL1; SL2] and [SL2; SL3] in a non limiting example.

Similarly the second template T2 comprises another plurality of set of coordinates. It has to be noted that the first template T1 and the second template T2 may comprise distinct plurality of sets of coordinates in a non limiting example, or they may share some common sets of coordinates COi in another non limiting example.

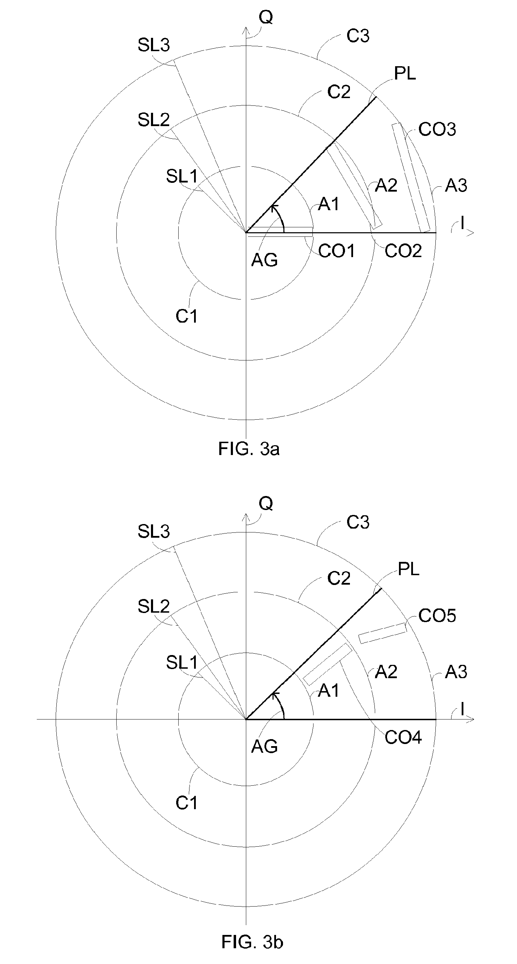

Referring to figure FIG. 3a, a schematic representation in an "I/Q" diagram of coordinates for configuring the decomposition of an input baseband signal according to the invention is depicted.

In this embodiment, one of the set of coordinates COi of the first template T1 is referenced hereinafter as the first set of coordinates C01. In order to simplify representation of the coordinates, it is considered only the decomposition of the input baseband signal IBS into the first outphased signal FOS and that the x-axis I of the "I/Q" diagram is collinear to the input baseband signal IBS. In another embodiment not depicted on figure FIG. 3a, the coordinates relative to the decomposition of the input baseband signal IBS into the second outphased signal SOS is symmetrical along the x-axis. The first set of coordinates C01 comprises coordinates for the amplification interval [0; SL1], wherein the first PA1 or second PA2 power amplifiers are considered to be solicited at lower power levels. In a non limiting example, the first PA1 or second PA2 power amplifiers may function in a linear regime on the amplification interval [0; SL1]. The decomposition of the input baseband signal, respectively into the first FOS and second SOS outphased signals and first FORS and SORS outphased radiofrequency signals may be then achieved with a null difference of phase.

The first set of coordinates C01 is advantageous in the case of low amplitude input baseband signal IBS, such as a zero input signal or a deep backed off input signal, which may be decomposed into collinear outphased signals.

In another embodiment, one of the set of coordinates COi of the first template T1 is referenced hereinafter as the second set of coordinates CO2. In order to simplify representation of the coordinates, it is considered only the decomposition of the input baseband signal IBS into the first outphased signal FOS and that the x-axis I of the "I/Q" diagram is collinear to the input baseband signal IBS.

The said second set of coordinates CO2 comprises coordinates corresponding to an approximation of a second arc A2 of a circle C2, said circle C2 being defined by a diameter dependent of the first saturation level SL2, and by an angle AG dependent of the first threshold TH1 and/or the criteria from the list LC. In the depicted non limiting example, by symmetry, the angle AG is half of the first threshold TH1. The second arc A2 is the portion of the circle C2 comprised between the x-axis I and a segment PL forming the angle AG with the x-axis I. The second set of coordinates CO2 comprises then coordinates corresponding to input baseband signal IBS, to be converted into the first outphased radiofrequency signal FORS, so that the said first outphased radiofrequency signal FORS is conditioned to have amplitude close to the saturation level SL2. The said second set of coordinates CO2 allows then the first PA1 power amplifier to be solicited by the first outphased radiofrequency signal FORS close to its saturation level SL1 wherein its efficiency is optimal. In a non limiting example, by symmetry, the image of the said second set of coordinates CO2 allows then the second PA2 power amplifier to be solicited by the second outphased radiofrequency signal SORS close to its saturation level SL1 wherein its efficiency is optimal.

Similarly, in another embodiment, a third set of coordinates CO3 is an approximation of a third arc A3. The third arc A3 of a circle C3 is characterized by its dependence with saturation level SL3 and the angle AG dependent of the first threshold TH1. Arc A3 is the portion of the circle C3 that is intersected by the x-axis I and the segment PL.

In a non limiting example, the second set of coordinates CO2 comprises coordinates that minimize their distance with the second arc A2.

In another non limiting example the third set of coordinates C03 comprises that minimize their distance with the second arc A2.

Referring to figure FIG. 3b, another schematic representation in an "I/Q" diagram of coordinates for configuring the decomposition of an input baseband signal according to the invention is depicted.

In this embodiment, one of the set of coordinates COi of the first template T1 is referenced hereinafter as the fourth set of coordinates C04. Similarly to figure FIG. 3a, in order to simplify representation of the coordinates, it is considered only the decomposition of the input baseband signal IBS into the first outphased signal FOS and that the x-axis I of the "I/Q" diagram is collinear to the input baseband signal IBS.

The fourth set of coordinates C04 minimizes the difference of phase between the first outphased radiofrequency signal FOS and the second outphased signal SOS on the amplification interval [SL1; SL2]. Since the "I/Q" diagram is oriented to have the x-axis I collinear to the input baseband signal IBS, the fourth set of coordinates C04 also minimizes the difference of phase between the first outphased signal FOS and the x-axis I. The coordinates of the fourth set C04 provide a compromise between:
- the coordinates of the second set of coordinates CO2, close to the arc A2 and allowing the first PA1 or second PA2 power amplifiers to be used in an efficient way.
- and the constraints on the difference of phase between the first outphased signal FOS and the second outphased radiofrequency signal SOS, which maximum contributes to the first threshold TH1 and the third criteria C3.

Similarly to the fourth set of coordinates C04, a fifth set of coordinates CO5 minimizes the difference of phase between the first outphased signal FOS and the second outphased signal SOS on the amplification interval [SL2; SL3]. The coordinates of the fifth set CO5 provide a compromise between:
- the coordinates of the third set of coordinates C03, close to the arc A3 and allowing the first PA1 or second PA2 power amplifiers to be used in a efficient way,
- and the constraints on the difference of phase between the first outphased signal FOS and the second outphased signal SOS, which maximum contributes to the first threshold TH1 and the third criteria C3.

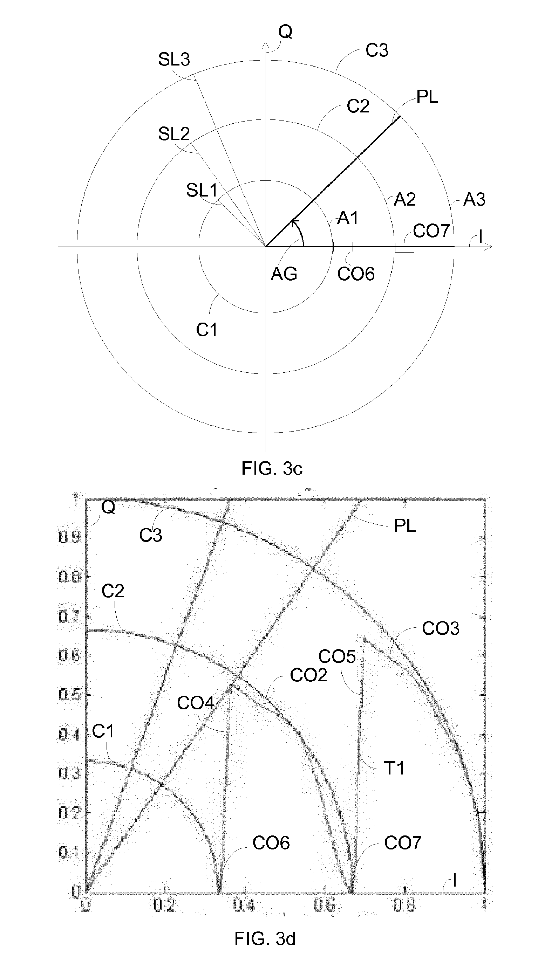

Referring to figure FIG. 3c, another schematic representation in an "I/Q" diagram of coordinates for configuring the decomposition of an input baseband signal according to the invention is depicted.

In yet another embodiment, one of the set of coordinates COi of the first template T1 is referenced hereinafter as the sixth set of coordinates C06. Similarly to figure FIG. 3a and FIG. 3b, in order to simplify representation of the coordinates, it is considered only the decomposition of the input baseband signal IBS into the first outphased radiofrequency signal FOS and that the x-axis I of the "I/Q" diagram is collinear to the input baseband signal IBS.

The sixth set of coordinates C06 comprises coordinates that are tangent to the x-axis I for the amplification interval [SL1; SL2], and close to the circle C1. These coordinates corresponds to signals to be amplified that are not matching the amplification [0; SL1], but are close to the saturation level SL1. The coordinates of the sixth set C06 provide a minimum phase difference between the first outphased signal FOS and the x-axis I, and similarly with the second outphased signal SOS, while the first PA1 or second PA2 power amplifiers are solicited in an amplification interval [SL1; SL2] at low amplification levels. In a non limiting example the coordinates of the sixth set CO6 define vectors in the "I/Q" diagram collinear to the x-axis I which is in this case also collinear to the input baseband signal IBS.

Similarly to the sixth set of coordinates CO6, a seventh set of coordinates C07 comprises coordinates that are tangent to the x-axis I for the amplification interval [SL2; SL3], and close to the circle C2. The coordinates of the seventh set C07 provide a minimum phase difference between the first outphased signal FOS and the x-axis I, and similarly with the second outphased signal SOS, while the first PA1 or second PA2 power amplifiers are solicited in an amplification interval [SL2; SL3] at low amplification levels. In a non limiting example the coordinates of the seventh set C07 define vectors in the "I/Q" diagram, for the first outphased signal FOS, collinear to the x-axis I which is in this case also collinear to the input baseband signal IBS.

It is important to note that, in another embodiment, by symmetry with the input baseband signal IBS, represented as the x-axis I in the figure FIG. 3a, 3b and 3c, set of coordinates corresponding to the decomposition of the input baseband signal IBS into the second outphased signal SOS can be obtained. The said symmetry is relative to the pairing of the first branch B1 and the second branch B2.

In another embodiment, wherein the first branch B1 and the second branch B2 are not paired, the set of coordinates corresponding to the decomposition of the input baseband signal IBS into the second outphased signal SOS are not obtained by symmetry but are obtained by considering specifically the characteristics of the second branch B2.

Referring to figure FIG. 3d, another schematic representation in an "I/Q" diagram of coordinates for configuring the decomposition of an input baseband signal according to the invention is depicted.

The first template T1 is depicted as a combination of the set of coordinates CO2, C03, C04, CO5, C06 and C07. In this non limiting example, the first set of coordinates C01 is the segment of the x-axis I comprised between the x-coordinates 0 and the circle C1. In a non limiting example, the coordinates comprised in the first template 1 are pre-calculated and stored in a lookup table.

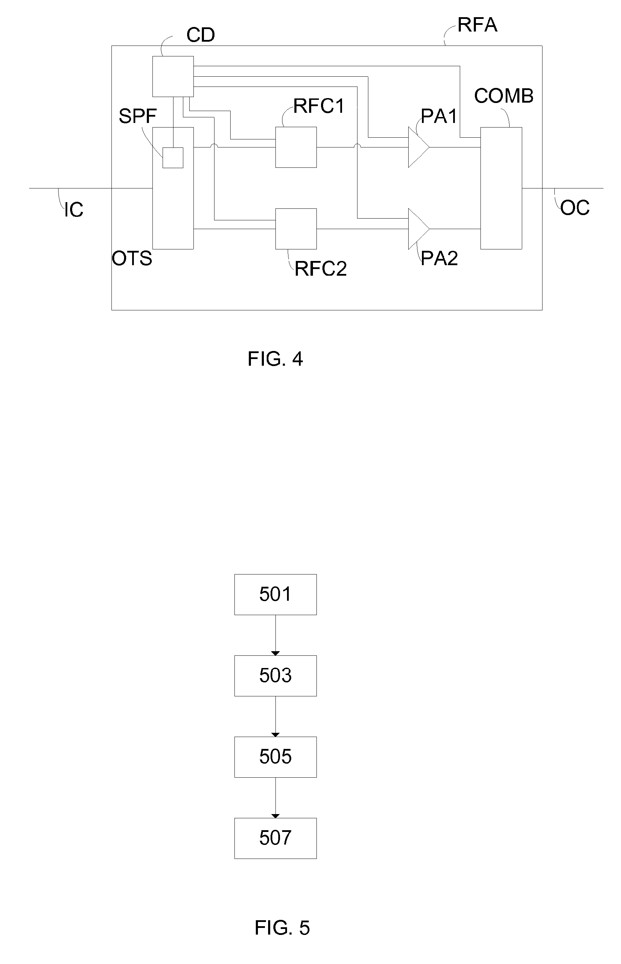

Referring to figure FIG. 4, a schematic block of radiofrequency amplifier device comprising a configuration device of a splitting function according to the invention is depicted. The radiofrequency amplifier device RFA comprises the outphasing splitter OTS, the first RFC1 and second RFC2 radiofrequency converters, the first PA1 and second PA2 power amplifiers and the combiner COMB. The input connection IC is the entry point for input signal and the output connection is an exit point to an amplified version of the input signal in the radiofrequency domain.

The radiofrequency amplifier device RFA further comprises a configuration device CD of the splitting function SPF of the outphasing splitter OTS. The said configuration device CD performs the method to configure the splitting function as described herein above. For that purpose, in an embodiment, the configuration device CD comprises means to interact with the elements of the radiofrequency amplifier device. The configuration device CD comprises means to connect respectively to the splitting function through the outphasing splitter, the first RFC1 and second RFC2 radiofrequency converters, the first PA1 and second PA2 power amplifiers and the combiner COMB. Through the said means, the configuration device CD is adapted to retrieve information from the elements of the radiofrequency amplifier device RFA in order to establish the first C1, the second C2, the third C3, the fourth C4 and the fifth C5 criteria. The configuration device CD performs then the method to configure the splitting function SPF.

In an embodiment, the configuration device CD comprises an interface to input and store the criteria from the list of criteria LC. Such means may be, in non limiting examples, a programmable interface accessible with a device manager, or a pre-configured memory electronically stored and coupled with the configuration device CD.

In another embodiment, the configuration device CD is adapted to store the list of criteria LC.

In another embodiment, the configuration device CD is adapted to interact with each of the elements of the radiofrequency amplifier device RFA, for receiving directly from them, the respective first C1, the second C2, the third C3, the fourth C4 and the fifth C5 criteria. In a non limiting example, such interaction and reception may be achieved with connections between the configuration device CD and each of the elements of the radiofrequency amplifier device RFA, wherein said connections comprised communication interface and protocol.

In another embodiment, the configuration device CD is adapted to interact with each of the elements the radiofrequency amplifier device RFA, for evaluating the respective first C1, the second C2, the third C3, the fourth C4 and the fifth C5 criteria. In a non limiting example, in such interaction, the configuration device CD receives raw characteristics of the elements of the radiofrequency amplifier device RFA, and then derives from these characteristics the criteria from the list of criteria LC.

In yet another embodiment, the configuration device is adapted to interrogate periodically the elements the radiofrequency amplifier device RFA in order to monitor a modification necessitating updating one of the criteria.

In a preferred embodiment the configuration device is comprised in the outphasing splitter OTS

In another embodiment it may be comprised in another element of the radiofrequency amplifier device RFA or it may be a standalone device.

The configuration device CD may be made of software, or hardware, or of a combination of software executed by hardware. The configuration device CD may comprises means of storage and computation to process the list of criteria and to configure the splitting function SPF.

Referring to figure FIG. 5, a flowchart showing steps of a method to perform amplification of an input signal is depicted. The method is performed on the input baseband signal IBS by a radiofrequency amplifier device RFA.

**Step 501:** The input baseband signal IBS is splitted respectively into the first outphased signal FOS and the second outphased signal SOS by the outphasing splitter OTS.

In this step 501, the amplitude and phase of the input baseband signal IBS are evaluated periodically by the outphasing splitter OTS, in order to determine and update a signal criteria SC. In a non limiting example, the amplitude and phase of the input baseband signal IBS are evaluated for each sample of the said input signal baseband signal.

The splitting of the input baseband signal IBS is performed by the splitting function SPF according to the said signal criteria SC, in order to determine in real-time the respective amplitudes and phases of the respective first outphased signal FOS and second outphased signal SOS. It is meant by real-time that the determination of the amplitudes and phases are performed regularly and for each sample of the input baseband signal IBS in another non limiting example.

The splitting function SPF is configured to ensure that the difference of phase DP between the produced first outphased signal FOS and second outphased signal SOS is less than the first threshold TH1.

**Step 503:** The first outphased signal FOS is converted from baseband domain to radiofrequency domain into the first outphased radiofrequency signal FOS. Similarly the second outphased signal SOS is converted from baseband domain to radiofrequency domain into the second outphased radiofrequency signal SOS. In a non limiting example, the conversions are performed at the same rate as the splitting of the input baseband signal IBS.

**Step 505:** The first outphased radiofrequency signal FORS is amplified by the first power amplifier PA1. Similarly the second outphased radiofrequency signal SORS is amplified by the second power amplifier PA2. In a non limiting example, the amplifications are performed at the same rate as the splitting of the input baseband signal IBS.

**Step 507:** The amplified first outphased radiofrequency signal FORS and second outphased radiofrequency signal SORS are combined into the output radiofrequency signal ORS. The said combination is performed by the combiner COMB, at the same rate as the splitting of the input baseband signal IBS in a non limiting example.

In an embodiment, the splitting function SPF operating at the step 501 for splitting the input baseband signal IBS is configured according to the method to perform configuration of said splitting function SPF, described herein above. The said configuration involves the determination of the first rule R1 in function of at least one criterion from the list of criteria LC.

Referring to FIG. 1a, the radiofrequency amplifier device RFA is depicted as described herein above.

In a preferred embodiment the radiofrequency amplifier device RFA comprises the outphasing splitter OTS, for splitting the input baseband signal IBS into respectively the first outphased signal FOS and the second outphased signal FOS. The splitting is performed by the splitting function SPF according to the signal criteria SC. The said signal criteria SC is representative of the amplitude and phase of the input baseband signal IBS, and are evaluated in real-time. The splitting function SPF performs the splitting by considering also the difference of phase DP between the first outphased signal FOS and the second outphased signal SOS, by ensuring that the said difference is less than the first threshold TH1. Then the respective amplitudes and phases of the respective first outphased signal FOS and second outphased signal SOS are calculated in real-time, in order to generate the said outphased signals by the outphasing splitter OTS.

The radiofrequency amplifier device RFA then process further the first outphased signal FOS and second outphased signal SOS, by respectively converting each of them in radiofrequency domain with the first radiofrequency converter RFC1 and the second radiofrequency converter RFC2. The converted outphased signals, respectively the first outphased radiofrequency signal FORS and the second outphased radiofrequency signal SORS are then amplified respectively by the first power amplifier PA1 and the second power amplifier PA2. The said amplified signals are then combined by the combiner COMB to generate the output radiofrequency signal ORS. This signal is an amplified replication of the input baseband signal IBS.

In another preferred embodiment, the splitting function SPF of the outphasing splitter OTS is configured by the configuration device CD described herein above. The configuration device CD, comprising means to interact with the outphasing splitter, the radiofrequency converters, the power amplifiers and the combiner, determines the first rule R1 in function of at least one criterion from the list of criteria LC, said first rule R1 configuring the splitting function SPF.

In yet another embodiment, the radiofrequency amplifier device RFA is an amplifier according to the technique Multi-Level Linear amplification using Nonlinear Components "ML LINC" or to the technique Asymmetric Multi-level Outphasing "AMO".

In a non limiting example, a "ML LINC" amplifier is a radiofrequency amplifier device that comprises power amplifiers for each branch carrying an outphased signal, said power amplifiers further comprising a plurality of saturation levels. The input baseband signal IBS is splitted into two outphased signals with similar or equal amplitudes. The additional constraint on the amplitudes of the two generated outphased signals is considered in the list of criteria LC, for the splitting function SPF to dynamically ensure that the difference of phase DP between the said outphased signals is less than the first threshold TH1.

In a non limiting example, an "AMO" amplifier is a radiofrequency amplifier device that splits the input baseband signal IBS into two outphased signals, each with specific amplitude. At the difference of the "ML LINC" amplifier, the first power amplifier PA1 and the second power amplifier PA2 may be solicited each with different power or voltage supply. In a non limiting example, for a specific extract of the input baseband signal IBS, the first outphased radiofrequency signal FORS is processed by the first power amplifier PA1 while being supplied with a power or voltage corresponding to the first saturation level SL1, and the second outphased radiofrequency signal SORS is processed by the second power amplifier PA2 while being supplied with a power or voltage corresponding to the third saturation level SL3. The multiple combination of the different power or voltage supply between the power amplifiers is considered in the list of criteria LC, for the splitting function to dynamically ensure that the difference of phase DP between the said outphased signals is less than the first threshold TH1.

In another embodiment, the radiofrequency amplifier device RFA comprises a "Chireix" coupler for the combiner COMB. The characteristics of the "Chirex" coupler are taken into account in the third criteria and in the first threshold TH1. In this embodiment, the outphasing splitter OTS decomposes the input baseband signal IBS into the first outphased signal FOS and the second outphased signal SOS with the first threshold TH1 limiting the difference of phase DP to 60°, in order to limit the load modulation induced by the "Chireix" coupler. This limit of difference of phase of 60° combined with the list of criteria LC, used by the first rule R1 in the splitting function SPF, guarantees that an optimal amplification efficiency of the radiofrequency amplifier device RFA.

In a preferred embodiment, the radiofrequency amplifier device RFA comprises an isolated coupler for the combiner COMB. The characteristics of the isolated coupler are taken into account in the third criteria and in the first threshold TH1. In this embodiment, the outphasing splitter OTS decomposes the input baseband signal IBS into the first outphased signal FOS and the second outphased signal SOS with the first threshold TH1 limiting the difference of phase DP to 20°, in order to limit the loss of power in a load resistor. This limit of difference of phase of 20° combined with the list of criteria LC, used by the first rule R1 in the splitting function SPF, guarantees that an optimal amplification efficiency of the radiofrequency amplifier device RFA.

The exposed embodiments provide means and methods to configure the splitting function SPF of the outphasing splitter OTS. The said configuration advantageously takes into consideration the characteristics of the radiofrequency amplifier device RFA, and the characteristics of the input signal to be amplified. This configuration allows adapting the decomposition of the input baseband signal in order to generate the outphased signals.

In the other exposed embodiments, the radiofrequency amplifier device RFA and a method for amplifying linearly benefits from the configuration of the splitting function SPF of the outphasing splitter OTS. The splitting of the input baseband signal IBS is performed to optimize the overall amplification efficiency of the radiofrequency amplifier device RFA.

The invention offers means and device to improve efficiency of a radiofrequency amplifier device CD using an isolated coupler as a combiner COMB. The use of an isolated coupler is a cost effective advantage over existing solution that requires more complex power combiners.

The invention also provides means and device to use the first power amplifier PA1 and the second power amplifier PA2 with an increased power or voltage drain efficiency. In a non limiting example, the invention allows to reach 65% of drain efficiency with the linearity compliancy as required by 3GPP standards.

The configuration of the splitting function SPF in function of the fifth criteria C5, according to the invention, allows advantageously limiting the increase of the spectrum bandwidth of the first outphased signal FOS and/or the second outphased signal SOS, while decomposing the input baseband signal IBS. The said limitation of increase of spectrum bandwidth allows then amplifying input baseband signal IBS with larger baseband bandwidth, by using already existing amplification architecture. It brings the possibility to re-use off the shelve radiofrequency amplifiers, or amplifiers modified with small cost.

Another advantage of the invention resides in the ability of the methods and devices to adapt dynamically to the input baseband signal IBS and to the characteristics of the radiofrequency amplifier device that may evolve over time. In a non limiting example, the performances of the combiner COMB may degrade over time, necessitating then to adapt the first threshold TH1 and the list of criteria LC, in order to configure accordingly the outphasing splitter OTS.

It should be appreciated by those skilled in the art that any block diagrams herein represent conceptual views of illustrative circuitry embodying the principles of the invention. Similarly, it will be appreciated that any flow charts, and the like represent various processes which may be substantially represented in computer readable medium and so executed by a computer or processor, whether or not such computer or processor is explicitly shown.

In the claims, any reference signs placed between parentheses shall not be construed as limiting the scope of the claims.

## Claims

1. A method for configuring a splitting function (SPF) of an outphasing splitter (OTS) of a radiofrequency amplification device (RFA) wherein an input baseband signal (IBS) is decomposed in a first outphased signal (FOS) and a second outphased signal (SOS), said first (FOS) and second (FOS) outphased signals corresponding to the input baseband signal (IBS) in an "I/Q" diagram, said method comprising the step of:
- determining a first rule (R1) in function of at least one criteria from a list of criteria (LC) representative of the characteristics of the radiofrequency amplification device (RFA),
- configuring the splitting function (SPF) with the first rule (R1) to ensure that the difference of phase (DP) between the first outphased signal (FOS) and the second outphased signal (SOS) is less than a first threshold (TH1).

2. A method according to claim 1, wherein the list of criteria (LC) comprises
- a first criteria (C1), function of the conditioning of the input baseband signal (IBS), such as the probability distribution function or the complementary cumulative distribution function or the sampling rate of the input baseband signal (IBS),
- a second criteria (C2), function of a first power amplifier (PA1) and a second power amplifier (PA2) of the radiofrequency amplification device (RFA), comprising each at least one saturation level (SL1; SL2; SL3), said first (PA1) and second (PA2) power amplifiers being used for amplifying respectively a first outphased radiofrequency signal (FORS) and a second outphased radiofrequency signal (SOS), said first outphased radiofrequency signal (FORS) being the first outphased signal (FOS) converted from baseband domain to radiofrequency domain by a first radiofrequency converter (RFC1), and said second outphased radiofrequency signal (SORS) being the second outphased signal (SOS) converted from baseband domain to radiofrequency domain by a second radiofrequency converter (RFC2),
- a third criteria (C3), function of the isolation constraints of a combiner (COMB) used for combining the amplified first outphased radiofrequency signal (FORS) and the amplified second outphased radiofrequency signal (SORS) into an output radiofrequency signal (ORS),
- a fourth criteria (C4), function of the linearity constraints of the output radiofrequency signal (ORS),
- a fifth criteria (C5), function of the maximum input spectrum bandwidths of the first radiofrequency converter (RFC1) and the second radiofrequency converter (RFC2).

3. A method according to any of the claims 1 or 2, wherein the first rule (R1) comprises the choice of at least one smoothing function (SMF1; SMF2), said at least one smoothing function (SMF1; SMF2) being configured by a template (T1; T2), for decomposing the input baseband signal into the first outphased signal (FOS) and the second outphased signal (SOS).

4. A method according to claim 3, wherein the template (T1; T2) comprises coordinates in the "I/Q" diagram, said coordinates being approximated by at least one lookup table or by at least one polynomials function.

5. A method according to claims 2 and 4, wherein the template (T1; T2) comprises at least one set of coordinates (CO2; C03) in the "I/Q" diagram, each set of coordinates (CO2; C03) corresponding to an approximation of an arc (A2; A3) of a circle (C2; C3), said circle (C2; C3) being defined by a diameter dependent to at least one saturation level (SL2; SL3), and said arc (A2; A3) being defined by an angle dependent to the first threshold (TH1).

6. A method according to claim 4 or 5, wherein the template (T1; T2) comprises at least one set of coordinates (C04; CO5) in the "I/Q" diagram, said at least one set of coordinates (C04; CO5) minimizing the difference of phase (DP).

7. A method according to any of the claims 4 to 6, wherein the template (T1; T2) comprises at least one set of coordinates (CO1; CO6; C07) in the "I/Q" diagram, said at least one set of coordinates (CO1; CO6; C07) comprises coordinates collinear to the input baseband signal IBS.

8. A configuration device (CD) of a splitting function (SPF) of an outphasing splitter (OTS) of a radiofrequency amplification device (RFA) wherein an input baseband signal (IBS) is decomposed in a first outphased signal (FOS) and a second outphased signal (SOS), said first (FOS) and second (FOS) outphased signals corresponding to the input baseband signal (IBS) in a I/Q diagram, comprising:
- means to determine a first rule (R1) in function of at least one criteria of a list of criteria (LC) representative of the characteristics of the radiofrequency amplification device (RFA),
- means to configure the splitting function (SPF) with the first rule (R1) to ensure that the difference of phase (DP) between the first outphased signal (FOS) and the second outphased signal (SOS) is less than a first threshold (TH1),
- means to configure the list of criteria (LC), said means being an input interface or means to evaluate the criteria from the list of criteria (LC) by interacting respectively with the outphasing splitter (OTS), a first radiofrequency converter (RFC1) and a second radiofrequency converter (RFC2), a first power amplifier (PA1) and a second power amplifier (PA2), a combiner (COMB), respectively comprised in the radiofrequency amplification device (RFA).

9. A method for amplifying linearly an input baseband signal (IBS), comprising the following steps performed by a radiofrequency amplifier device (RFA):
- decomposing (501) the input baseband signal (IBS) in a first outphased signal (FOS) and a second outphased signal (SOS) corresponding to the input baseband signal (IBS) in a I/Q diagram, wherein the respective amplitudes and phases of the respective first outphased signal (FOS) and second outphased signal (SOS) are calculated in real-time, by a splitting function (SPF) configured to ensure that the difference of phase (DP) between the first outphased signal (FOS) and the second outphased signal (SOS) is less than a first threshold (TH1), and in function of a signal criteria (SC) representative of amplitude and phase of the input baseband signal (IBS),
- converting (503) from baseband to radiofrequency the first outphased signal (FOS) and the second outphased signal (SOS) into respectively a first outphased radiofrequency signal (FORS) and a second outphased radiofrequency signal (SORS),
- amplifying (505) the first outphased radiofrequency signal (FORS) and the second outphased radiofrequency signal (SORS),
- combining (507) the said amplified first outphased radiofrequency signal (FORS) and second outphased radiofrequency signal (SORS), into an output radiofrequency signal (ORS).

10. A method according to claim 9, wherein the splitting function (SPF) is configured by the method according to any of the claims 1 to 7.

11. A radiofrequency amplification device (RFA) for amplifying an input baseband signal (IBS) and comprising:
- an outphasing splitter (OTS) comprising a splitting function (SPF), for decomposing the input baseband signal (IBS) respectively into a first outphased signal (FOS) and a second outphased signal (SOS), wherein the said first (FOS) and second (FOS) outphased signals corresponding to the input baseband signal (IBS) in a I/Q diagram, and the respective amplitudes and phases of the respective first outphased signal (FOS) and second outphased signal (SOS) are calculated in real-time, by said splitting function (SPF) being configured to ensure that the difference of phase (DP) between the first outphased signal (FOS) and the second outphased signal (SOS) is less than a first threshold (TH1), and in function of a signal criteria (SC) representative of amplitude and phase of the input baseband signal (IBS),
- a first radiofrequency converter (RFC1) and a second radiofrequency converter (RFC2) to convert from baseband to radiofrequency the first outphased signal (FOS) and the second outphased signal (SOS) respectively into a first outphased radiofrequency signal (FORS) and a second outphased radio frequency signal (SORS),
- a first power amplifier (PA1) and a second power amplifier (PA2) for amplifying respectively the first outphased radiofrequency signal (FORS) and the second outphased radiofrequency signal (SORS),
- a combiner (COMB) to combine the amplified first outphased radiofrequency signal (FORS) and second outphased radiofrequency signal (SORS), into an output radiofrequency signal (ORS).

12. A radiofrequency amplification device (RFA) according to claim 11, wherein the splitting function is configured by the configuration device according to claim 8.

13. A radiofrequency amplification device (RFA) according to any of claims 11 to 12, wherein the radiofrequency amplification device (RFA) is an amplifier according to the technique Multi-Level Linear amplification using Nonlinear Components "ML LINC" or to the technique Asymmetric Multi-level Outphasing "AMO".

14. A radiofrequency amplification device (RFA) according to any of the claims 11 to 13, wherein the difference of phase between the first outphased signal (FOS) and the second outphased signal (SOS) is less or equal to 60°, and the combiner (COMB) is a coupler using "Chireix" coupling technique.

15. A radiofrequency amplification device (RFA) according to any of the claims 11 to 13, wherein he difference of phase between the first outphased signal (FOS) and the second outphased signal (SOS) is less or equal to 20°, and the combiner (COMB) is an isolated coupler.
